Europäisches Patentamt

European Patent Office

Office européen des brevets

(11) Publication number: **0 212 120**
A1

# (12) EUROPEAN PATENT APPLICATION

(21) Application number: 86108152.9

(22) Date of filing: 14.06.86

(51) Int. Cl.⁴: **H 01 L 31/10, H 01 L 29/60, H 01 L 29/10**

(30) Priority: 21.06.85 GB 8515801

(43) Date of publication of application: 04.03.87 Bulletin 87/10

(84) Designated Contracting States: DE FR IT NL

(71) Applicant: ITT INDUSTRIES INC., 320 Park Avenue, New York, NY 10022 (US)

(72) Inventor: Thompson, Georg Horace Brooke, 20 Hoestock Road, Sawbridgeworth Herts, CM21 0DZ (GB)

(74) Representative: Morstadt, Volker, Dipl.-Ing. et al, c/o Deutsche ITT Industries GmbH Patent/Lizenzabteilung Postfach 840 Hans-Bunte-Strasse 19, D-7800 Freiburg/Brsg. (DE)

(54) Field effect phototransistor.

(57) A photoconductor comprising an optically sensitive field-effect transistor and including an appropriately biassed insulated metal gate (5, 6) for gain enhancement. The slow carriers are thus attracted to the semiconductor/ insulator interface where the longitudinal field is smaller and thus their transit time, and the gain, is increased. The AC-earthed gate contact (Schottky contact) (7) can be used to extract the slow carriers noiselessly after their transit if required. By providing a heterojunction at the gate contact (Fig. 2) any deleterious influence of the insulator interface states can be reduced.

G.H.B.Thompson 39

Fl 1295 EP

Dr.P.l/bk

13.06.1986

TITLE MODIFIED
see front page

## PHOTOCONDUCTOR

This invention relates to photoconductors and in particular to optically sensitive field effect transistors (FET).

According to the present invention there is provided a photoconductor comprising an optically sensitive field effect transistor and including an insulated gate associated with a channel region thereof.

Embodiments of the present invention will now be described with reference to the accompanying drawings, in which:-

Fig. 1 illustrates a cross-section through an embodiment of photoconductor according to the present invention together with associated electrical circuitry, and

Fig. 2 illustrates a cross-section through another embodiment of photoconductor according to the present invention.

A conventional compound semiconductor junction FET may be used as an optically sensitive FET. Such a device comprises a semi-insulating substrate upon which is a relatively high conductivity channel layer. Source, drain and gate contacts are made to the channel layer from the same surface thereof. The device may be employed to detect light incident on said surface or light incident on the transparent semi-insulating substrate from underneath. When light is incident on the channel layer photon-induced electron-hole pairs are created. The electrons of the pairs are driven away from the gate contact into the non-depleted part of the channel and then drift towards the drain contact and the holes of the pairs are driven towards the gate contact.

The gain of a photoconductor cannot exceed the ratio of the transit times of the slow to the fast carrier. The transit time of the slow carriers, and hence the gain, may be increased by placing an insulated gate between the photoconductor contacts and biassing appropriately. The slow carriers are attracted to and retained at the semicondcutor/insulator interface where the longitudinal field is smaller. This field, and hence the gain, is adjustable with the bias volts, which should be applied through a long-time-constant resistor. A separate appropriately biased AC-earthed gate contact can be used to extract slow carriers noiselessly after their transit.

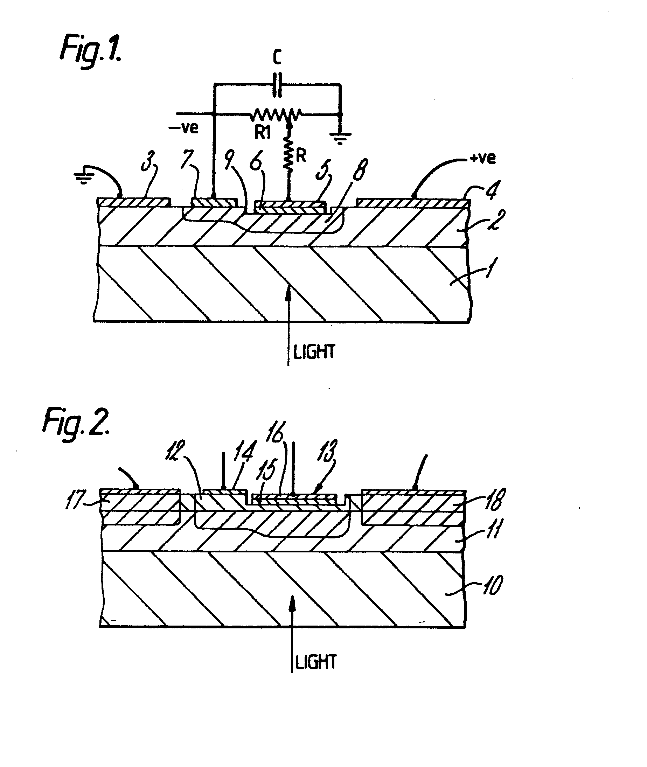

A simple embodiment of such an enhanced gain insulated gate photoconductor is shown in Fig. 1. It comprises a transparent semi-insulating substrate 1 of, for example, InP on which light is incident from beneath as indicated, with a channel layer 2 of, for example n GaInAs, to which are applied ohmic contacts 3 and 4, one of which is illustrated as earthed whilst the other is positively biassed. A Schottky metal gate 5 is insulated from the channel layer 2 by an insulating layer 6. A second gate 7 comprised by a Schottky contact is also applied to the channel layer 2. The second gate 7 is negatively biased and AC earthed as indicated by means of capacitor C. The insulated metal gate 5 is negatively biased through a long-time-constant resistor R and the voltage is adjustable as indicated by the potentiometer R1. The Schottky metal gate 5 may be of Ti/Au, Cr/Au or Pt, for example. The insulating layer 6 may be of silicon dioxide or silicon nitride, for example. The second gate may be of Ti/Au, or Cr/Au and the ohmic contacts may be of alloyed AuGe/Ni/Au.

A depletion region 8 is formed in the channel layer. Since there is a higher voltage on the second gate 7 than the metal gate 5 a larger gap between the depletion region and the substrate is required under the second gate in order to avoid pinch-off to the surface. In order to achieve this the insulating layer 6 is indicated as disposed in a recess 9 in the surface of the channel layer 2, this results in the illustrated stepped configuration of the depletion region 8. The value of R is chosen such that R times the gate capacitance is greater than the hole transit time. The insulating layer 6 is chosen such as to obtain a good confinement barrier with few interface states and may be of the order of 5-10nm thick silicon dioxide. As mentioned above the effect of the insulated gate is to attract the slow carriers to the surface and then the second gate extracts them noiselessly after transit thereto.

The embodiment of Fig. 2 includes a heterojunction to trap the majority of holes, instead of the semiconductor/insulator interface of the Fig. 1 embodiment, and to reduce leakage at the un-insulated second gate. A photoconductor including a heterojunction in the channel region has already been proposed in

. One such previously proposed construction of photoconductor had an embedded gate and this device has proved to be temperature sensitive. With a properly made insulated gate disposed on the channel layer as proposed in the present invention, however, the slow carriers cannot penetrate the insulating layer and drift sideways thereunder so that the device is not so temperature sensitive.

The heterojunction - including structure of Fig. 2 is manufactured from a transparent semi-insulating substrate 10, on which is an n⁻GaInAs channel layer 11 on which is an undoped InP layer 12. Two gates 13 and 14 are provided. An insulated metal gate 13 comprises an insulating layer 15 disposed in a recess in layer 12 with a Schottky metal layer 16 thereon. The uninsulated gate 14 comprises a Schottky metal layer disposed directly on layer 12. Disposing the insulated gate in the recess provides the same depletion region shape as in Fig. 1 in order to prevent pinch-off. In order to provide source and drain contact to the channel layer 11 the undoped InP layer 12 is ion implanted $n^+$ at 17 and 18. Thus there is provided a heterojunction beneath the insulated gate at which the majority of the holes are retained and which is likely to provide less restriction to their flow in the longitudinal direction and fewer centres at which they can be trapped or recombine or be regenerated than the semiconductor/insulator interface. This leads to an improvement in time response and a reduction in noise.

CLAIMS:-

1.      A photoconductor comprising an optically sensitive field effect transistor and including an insulated gate associated with a channel region thereof.

2.      A photoconductor as claimed in claim 1 and including an uninsulated gate contact to the channel region adjacent to the insulated gate.

3.      A photoconductor as claimed in claim 1 or claim 2 including two electrical contacts to the channel region, the insulated gate being disposed between the two electrical contacts.

4.      A photoconductor as claimed in claim 3 wherein the photoconductor is disposed on a surface of a transparent semiconductor substrate.

5.      A photoconductor as claimed in claim 3 as appendent to claim 2 and comprising a transparent semi-insulating InP substrate, a layer of $n^-GaInAs$ disposed on a surface of the substrate and providing the channel region, the two electrical contacts comprising ohmic contacts to the channel region, the insulated gate being comprised by an insulating layer on a portion of the surface of the channel region with a layer of Schottky metal thereon and the uninsulated gate contact being comprised by a Schottky contact.

6.      A photoconductor as claimed in claim 5 whereinthe thickness of the channel region is reduced at said surface portion whereby the depletion region portion associated with said uninsulated gate contact is spaced further from the semi-insulating substrate than the depletion region portion associated with the insulated gate whereby to prevent pinch-off to the substrate.

7.      A photoconductor as claimed in claim 5 or claim 6 wherein in use the uninsulated gate contact is AC-earthed and the gain is adjustable by varying the bias voltage applied to the insulated gate.

8.      A photoconductor as claimed in claim 3 as appendant to claim 2 and comprising a transparent semi-insulating InP substrate, a layer of $n^-$GaInAs disposed on a surface of the substrate and providing the channel region, and a layer of undoped InP disposed on a region of the surface of the channel region, the insulated gate and the uninsulated gate contact being disposed on the InP layer, the insulated gate being comprised by an insulating layer on a portion of the InP layer with a layer of a Schottky metal thereon and the uninsulated gate contact being comprised by a Schottky contact.

9. A photoconductor as claimed in claim 7 wherein the thickness of the InP layer is reduced at said portion thereof whereby the depletion region portion in the channel region associated with said uninsulated gate contact is spaced further from the semi-insulating substrate than the depletion region portion associated with the insulated gate whereby to prevent pinch-off to the substrate.

10. A photoconductor as claimed in claim 8 or claim 9 wherein the electrical contacts to the channel region are comprised by ohmic contacts to $n^+$ regions ion implanted through portions of the undoped InP layer on the $n^-$GaInAs layer.

**Fig.1.**

LIGHT

**Fig.2.**

LIGHT

0212120

**European Patent Office**

**EUROPEAN SEARCH REPORT**

Application number

EP 86 10 8152

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENTS ABSTRACTS OF JAPAN, Vol.6, no.72 (E-105)[950], May 7, 1982, & JP-A- 57 12 570 (NIPPON DENSHIN DENWA KOSHA) 22.01.1982 * Abstract * | 1,3,5, 10 | H 01 L 31/10 H 01 L 29/60 H 01 L 29/10 |
| X | PATENTS ABSTRACTS OF JAPAN, Vol.6, no.87, (E108)[965], May 25, 1982, & JP-A- 57 23 280 (NIPPON DENSHIN DENWA KOSHA) 06.02.1982 * Abstract * | 1,3,5 | |
| X | EP-A-0 060 657 (JUJITSU Ltd.) * Page 39, line 16 - page 40, line 35; figures 9,10 * | 1,3 | |
| A | | 5,8 | TECHNICAL FIELDS SEARCHED (Int. Cl.4) H 01 L |
| A | US-A-4 496 964 (N. TSUBOUCHI et al.) * The whole document * | 1,3,5 | |
| A | DE-A-3 440 674 (GENERAL MOTORS CORP.) | | |
| A | DE-A-3 344 637 (J. NISHIZAWA) | | |

The present search report has been drawn up for all claims

| Place of search | Date of completion of the search | Examiner |
|---|---|---|
| THE HAGUE | 12-09-1986 | VISENTIN A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82